# EUROPEAN PATENT APPLICATION

(11) **EP 4 657 057 A1**
(43) Date of publication of application: **03.12.2025**
(21) Application number: 25180008.2
(22) Date of filing: 30.05.2025
(51) Int. Cl.: G01N 29/04, G01N 29/22, G01N 29/24, G01N 29/44

(54) **INSPECTING POWERPLANT COMPONENT USING ACTUATOR-SENSOR STACK**

(30) Priority: 31.05.2024 US 202418680681
(71) Applicant: RTX Corporation, Farmington, CT 06032 (US)
(72) Inventor: KOETSCH, Christopher, East Longmeadow, 01028 (US); CURTIS, Alan R., Acton, 01720 (US); WINNEG, Nathan I., Somerville, 02143 (US)
(74) Representative: Dehns

(57) **Abstract**

An inspection method is provided during which an inspection device is arranged with a specimen component (22). The inspection device includes a piezoelectric actuator (40), an isolator (58) and a piezoelectric sensor (42). The piezoelectric actuator (40) engages and is preloaded against a surface of the specimen component (22) sequentially through the isolator (58) and the piezoelectric sensor (42). The isolator (58) electrically isolates the piezoelectric actuator (40) from the piezoelectric sensor (42). Vibrations are induced in the specimen component (22) using the piezoelectric actuator (40). A vibratory response in the specimen component (22) excited by the vibrations is measured using the piezoelectric sensor (42). Response data indicative of the vibratory response measured is provided using the piezoelectric sensor (42).

## Description

### BACKGROUND OF THE DISCLOSURE

### 1. Technical Field

This disclosure relates generally to inspection and, more particularly, to non-destructive inspection for internal defects.

### 2. Background Information

Various systems and methods are known in the art for inspecting a component for internal defects. While these known inspection systems and methods have various benefits, there is still room in the art for improvement.

### SUMMARY OF THE DISCLOSURE

According to an aspect of the present disclosure, an inspection method is provided during which an inspection device is arranged with a specimen component. The inspection device includes a piezoelectric actuator, an isolator and a piezoelectric sensor. The piezoelectric actuator engages and is preloaded against a surface of the specimen component sequentially through the isolator and the piezoelectric sensor. The isolator electrically isolates the piezoelectric actuator from the piezoelectric sensor. Vibrations are induced in the specimen component using the piezoelectric actuator. A vibratory response in the specimen component excited by the vibrations is measured using the piezoelectric sensor. Response data indicative of the vibratory response measured is provided using the piezoelectric sensor.

According to another aspect of the present disclosure, another inspection method is provided during which an inspection device is arranged with a specimen component. The inspection device includes an actuator and a sensor. The actuator engages and is preloaded against a surface of the specimen component through the sensor. An actuation voltage is applied across the actuator to induce vibrations in the specimen component using the actuator. A sensor voltage is measured across the sensor during inducement of the vibrations in the specimen component. A measured resonance signature of the specimen component is determined using the actuation voltage and the sensor voltage. The measured resonance signature is compared to a model resonance signature for a model component to determine a characteristic of the specimen component.

According to still another aspect of the present disclosure, a system is provided for inspecting a specimen component. This system includes an inspection device, a voltage meter and a processing device. The inspection device includes an actuator, an isolator and a sensor arranged in a stack. The isolator is configured to electrically isolate the actuator from the sensor. The inspection device is configured to preload the actuator against a surface of the specimen component sequentially through the isolator and the sensor. The actuator includes a piezoelectric device configured to induce vibrations in the specimen component. The sensor includes a piezoelectric device configured to measure a vibratory response in the specimen component. The voltage meter is configured to measure a sensor voltage across the piezoelectric device of the sensor during inducement of the vibrations in the specimen component by the actuator. The processing device is configured to determine a characteristic of the specimen component using the sensor voltage and an actuation voltage applied across the piezoelectric device of the actuator to induce the vibrations in the specimen component.

The following optional features may be applied to any of the above aspects.

The sensor may be solely connected to the actuator through the isolator. The isolator may be or otherwise include a ceramic.

The inspection device may also include an isolator arranged between the actuator and the sensor. The isolator may electrically isolate a piezoelectric device of the actuator from a piezoelectric device of the sensor.

The measuring of the vibratory response may include measuring a sensor voltage across the piezoelectric sensor.

The response data may be provided based on the sensor voltage and an actuator voltage applied across the piezoelectric actuator during the inducing of the vibrations.

The inspection method may also include: determining a measured resonance signature of the specimen component using the response data; and comparing the measured resonance signature to a model resonance signature for a model component. The specimen component and the model component may have a common configuration.

The model component may be a computer modeled component.

The model component may be a previously inspected component.

The inspection method may also include determining a characteristic of the specimen component using the response data.

The inspection method may also include detecting a defect internal to the specimen component using the response data.

The isolator may be bonded to the piezoelectric actuator.

The isolator may be bonded to the piezoelectric sensor.

The isolator may be or otherwise include a ceramic.

The inspection device may be configured as or otherwise include an inspection scope. The piezoelectric actuator, the isolator and the piezoelectric sensor may be included in a head of the inspection scope.

The inspection method may also include inserting the inspection device into an interior of a powerplant. The powerplant may include the specimen component within the interior of the powerplant.

The powerplant may be configured as or otherwise include a turbine engine.

The specimen component may be configured as a rotor disk.

The powerplant may be installed with an aircraft during the inserting, the arranging, the inducing and the measuring.

The present disclosure may include any one or more of the individual features disclosed above and/or below alone or in any combination thereof.

The foregoing features and the operation of the invention will become more apparent in light of the following description and the accompanying drawings.

### BRIEF DESCRIPTION OF THE DRAWINGS

FIG. 1 is a schematic illustration of a system for inspecting a component of a powerplant.
FIGS. 2A-C are schematic illustrations of a portion of the inspection system with the powerplant component, where an anchor of the inspection system is in various deployed arrangements.
FIG. 3 is a flow diagram of a method for inspecting a component of a powerplant.
FIGS. 4A-C are schematic illustrations of a portion of the inspection system with the powerplant component, where the anchor is in various stowed arrangements.
FIGS. 5A and 5B are graphs of various measured resonant signatures compared to a model resonant signature.

### DETAILED DESCRIPTION

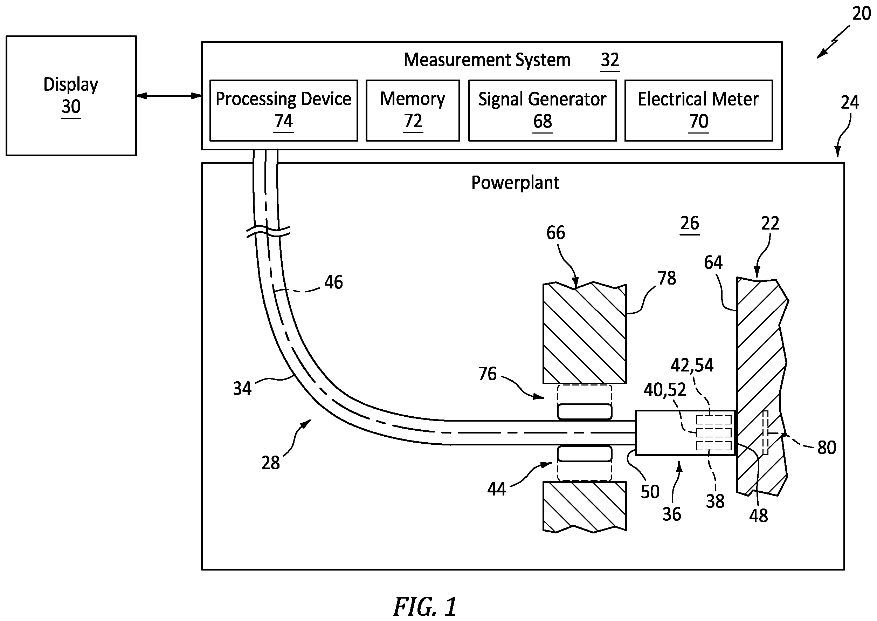

FIG. 1 illustrates a system 20 for non-destructive inspecting a component 22 of a powerplant 24 for an aircraft. The aircraft may be an airplane, a helicopter, a drone (e.g., an unmanned aerial vehicle (UAV)) or any other manned or unmanned aerial vehicle or system. The aircraft powerplant 24 may be configured as, or otherwise included as part of, a propulsion system for the aircraft. The aircraft powerplant 24, for example, may be a turbofan engine, a turbojet engine, a turboprop engine, a turboshaft engine, or any other type of gas turbine engine configured to generate thrust and/or drive rotation of a ducted or open propulsor rotor configured to generate thrust. The aircraft powerplant 24 may alternatively be configured as, or otherwise included as part of, a power generation system for the aircraft. The aircraft powerplant 24, for example, may be an auxiliary power unit (APU) or any other type of gas turbine engine configured to mechanically power operation of an electrical generator. The present disclosure, however, is not limited to such exemplary aircraft powerplants. The inspection systems and methods of the present disclosure, for example, may also be used for inspecting components of other types of internal combustion engines and/or components of various other types of power units; e.g., an electric machine, a hybrid-electric power unit, etc.

The inspection system 20 is configured to facilitate inspection of the powerplant component 22 while that powerplant component 22 remains installed with the aircraft powerplant 24 and, for example, while the aircraft powerplant 24 remains substantially or completely assembled. The powerplant component 22 of FIG. 1, for example, is disposed within an interior 26 (e.g., an enclosed volume, an encased volume, etc.) of the aircraft powerplant 24. The inspection system 20 is also configured to facilitate inspection of the powerplant component 22 while the aircraft powerplant 24 remains onboard the aircraft; e.g., remains installed on wing, on fuselage, in airframe, etc. The inspection of the powerplant component 22 may also be performed using the inspection system 20 while outside of an aircraft hangar and/or a dedicated inspection and/or repair facility; e.g., on a tarmac at an airport between aircraft flights. The inspection of the powerplant component 22 may thereby be performed with a relatively short aircraft downtime and/or a relatively minimal expense. The inspection system 20, of course, may also be used for inspecting the powerplant component 22 installed with the aircraft powerplant 24 when that aircraft powerplant 24 is not installed with the aircraft (e.g., prior to installation with the aircraft or following removal from the aircraft) and/or when the aircraft powerplant 24 is partially disassembled into one or more sub-assemblies.

The powerplant component 22 may be any inspectable (e.g., metal) component within the aircraft powerplant 24. However, for ease of description, the powerplant component 22 may be described below as a rotor disk of a bladed rotor within a gas turbine engine, and the aircraft powerplant 24 may be described below as the gas turbine engine. The rotor disk may be a turbine disk such as a rotor disk in a high pressure turbine (HPT) section or a low pressure turbine (LPT) section of the gas turbine engine. Alternatively, the rotor disk may be a compressor disk such as a rotor disk in a low pressure compressor (LPC) section or a high pressure compressor (HPC) section of the gas turbine engine. The present disclosure, however, is not limited to such exemplary powerplant component configurations. The powerplant component 22, for example, may alternatively be configured as a hub, a shaft or any rotating component within the aircraft powerplant 24.

The inspection system 20 may be configured as an inspection scope inspection system. The inspection system 20 of FIG. 1, for example, includes an inspection device such as an electronic inspection scope 28, a display 30 and a measurement system 32. Examples of the display 30 include, but are not limited to, a screen, a monitor and/or a touch screen.

The inspection scope 28 may be configured as or otherwise include a borescope or another flexible or rigid elongated probe. The inspection scope 28 of FIG. 1, for example, includes a scope body 34 (e.g., a flexible tether), a scope head 36, a scope sensor 38, a vibration actuator 40 and a vibration sensor 42. The inspection scope 28 may also include a scope anchor 44 such as, but not limited to, a fluidic and/or mechanically expandable mount for the inspection scope 28. The scope anchor 44 of FIG. 1 is schematically shown in a stowed arrangement by a solid line and in a deployed arrangement by the dashed line. Alternatively, the scope anchor 44 may be omitted where, for example, the scope head 36 and/or the scope body 34 are alternatively supported by a guide tube (e.g., a rigid tube) inserted into the interior 26 of the aircraft powerplant 24. However, for ease of description, the inspection scope 28 may be described below with the scope anchor 44.

The scope body 34 extends longitudinally along a longitudinal centerline 46 of the inspection scope 28 and its members 34 and 36 from a base end of the inspection scope 28 to the scope head 36. The scope body 34 is a flexible body. The scope body 34 may include one or more internal actuators for manipulating a configuration of the inspection scope 28 and its scope body 34 to aid in maneuvering the scope head 36 within the interior 26 of the aircraft powerplant 24 to the powerplant component 22.

The scope head 36 is disposed at a longitudinal distal end 48 of the inspection scope 28. The scope head 36 of FIG. 1, for example, extends longitudinally along the centerline 46 from a longitudinal proximal end 50 of the scope head 36 to the scope distal end 48 of the inspection scope 28; here, also a longitudinal distal end of the scope head 36. The scope sensor 38, the vibration actuator 40 and the vibration sensor 42 are each arranged with (e.g., mounted to and/or disposed in) the scope head 36. The vibration actuator 40 and the vibration sensor 42 of FIG. 1 and, optionally, the scope sensor 38 are also each disposed at (e.g., on, adjacent or proximate) the scope distal end 48.

The scope sensor 38 is configured to aid in the maneuvering of the scope head 36 and, more particularly, the vibration actuator 40 and the vibration sensor 42 within the interior 26 of the aircraft powerplant 24 towards the powerplant component 22. The scope sensor 38, for example, may be configured as a camera (e.g., a still image camera and/or a video camera), a proximity sensor, or the like which (e.g., in real time) locates the scope head 36 and/or the scope members during the maneuvering of the scope head 36, within the interior 26 of the aircraft powerplant 24, towards the powerplant component 22.

The vibration actuator 40 is configured to induce vibrations in the powerplant component 22 based on a control signal received from the measurement system 32. The vibration sensor 42 is configured to measure a vibratory response in the powerplant component 22 excited by the vibrations induced by the vibration actuator 40.

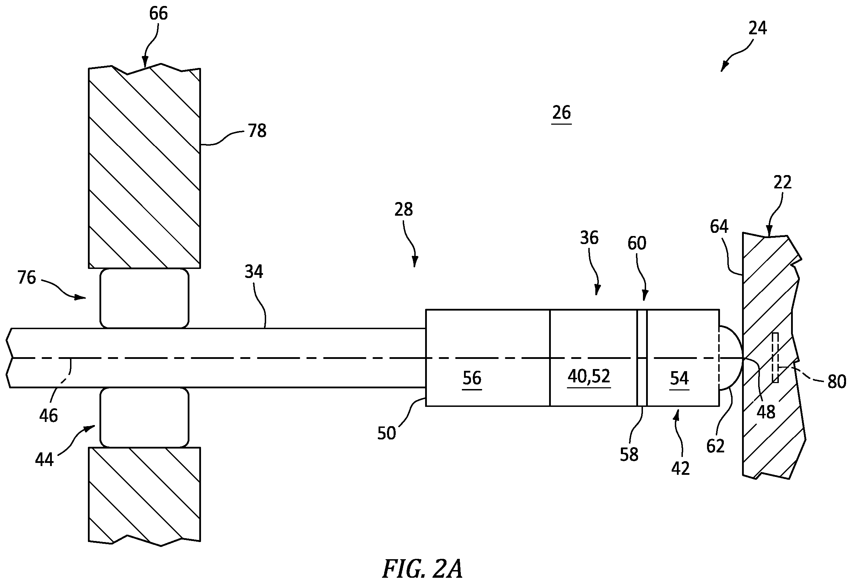

The vibration actuator 40 and the vibration sensor 42 may each be configured as or otherwise include a piezoelectric device 52, 54; see also FIGS. 2A-C. The piezoelectric device 52 is a piezoelectric actuator and is referred to below as an actuator piezoelectric device. The piezoelectric device 54 is a piezoelectric sensor and is referred to below as a sensor piezoelectric device. Examples of the piezoelectric device 52, 54 include, but are not limited to, a piezoelectric stack and a single crystal piezoelectric device. The piezoelectric stack may include a longitudinal stack (or multiple layers) of piezoelectric actuators. The single crystal piezoelectric device may include a piezoelectric ceramic element with a single crystal orientation and no grain boundaries. In general, the single crystal piezoelectric device may provide higher power and greater sensitivity than a comparable piezoelectric stack. The present disclosure, however, is not limited to the foregoing exemplary piezoelectric device configurations.

The vibration actuator 40 of FIGS. 2A-C is connected to a base 56 of the scope head 36. This head base 56 forms a support structure for the scope members 40 and 42. The head base 56 also connects the scope members 40 and 42 to the scope body 34. The vibration sensor 42 of FIGS. 2A-C is connected to the vibration actuator 40 through an electrical isolator 58; e.g., an insulator. This electrical isolator 58 may provide a sole structural link and a sole load path between (a) the vibration actuator 40 and its actuator piezoelectric device 52 and (b) the vibration sensor 42 and its sensor piezoelectric device 54. The electrical isolator 58 of FIGS. 2A-C, for example, extends longitudinally between, physically separates and may be attached (e.g., bonded) to a proximal end (e.g., a back end) of the vibration sensor 42 and its sensor piezoelectric device 54 and a distal end of the vibration actuator 40 and its actuator piezoelectric device 52. The members 56, 40, 58 and 42 of the scope head 36 may thereby form a stack 60, where the stack members 56, 40, 58 and 42 are arranged sequentially along the centerline 46 between the head proximal end 50 and the scope distal end 48. In FIGS. 2A-C, the vibration sensor 42 includes its sensor piezoelectric device 54 as well as a stiff / rigid contactor head 62 forming the scope distal end 48. This contactor head 62 may form a single contact point for the scope head 36 and its stack 60 to engage the powerplant component 22. The contactor head 62 may be a hemispherical piece of ceramic such as alumina (Al₂O₃) bonded to the sensor piezoelectric device 54.

The electrical isolator 58 is configured to electrically isolate the vibration actuator 40 from the vibration sensor 42, and vice versa. However, the electrical isolator 58 is also configured to transfer a longitudinal force from the vibration actuator 40 to the vibration sensor 42. The vibration sensor 42 may thereby be preloaded (e.g., directly) against an exterior surface 64 of the powerplant component 22 during the inspection of the powerplant component 22 as described below in further detail. The vibration actuator 40 may also be preloaded (e.g., indirectly) against the component surface 64 during the inspection of the powerplant component 22, sequentially through the electrical isolator 58 and the vibration sensor 42 longitudinally along the centerline 46. In general, therefore, the stack 60 and each of its members 40, 58, 42 may be preloaded against the component surface 64 during the inspection of the powerplant component 22.

The electrical isolator 58 is constructed from or may otherwise include an isolator material. This isolator material is selected to facilitate the electrical isolation between the vibration actuator 40 and the vibration sensor 42. The isolator material, for example, may be an electrical insulator (e.g., a dielectric). An example of the isolator material is a ceramic such as, but not limited to, alumina (Al₂O₃). The present disclosure, however, is not limited to such an exemplary isolator material.

The scope anchor 44 may be disposed with and/or connected to the scope head 36. The scope anchor 44 may alternatively (or also) be disposed with and/or connected to the scope body 34, for example at the head proximal end 50 or otherwise near the scope head 36 and its head proximal end 50. The scope anchor 44 is configured to anchor the inspection scope 28 within the aircraft powerplant 24 to fix a position of the scope head 36 within the interior 26 of the aircraft powerplant 24 relative to the powerplant component 22. Moreover, the scope anchor 44 is configured to maintain engagement (e.g., contact and/or a preload) between the stack 60 and its vibration sensor 42 and the component surface 64, for example once the scope head 36 is in its fixed position next to the powerplant component 22 within the interior 26 of the aircraft powerplant 24. The scope anchor 44 of FIGS. 2A-C, for example, is configured to expand in size (e.g., lateral width, diameter, circumference, etc.) in order to engage another component 66 within the interior 26 of the aircraft powerplant 24 that is next to or near the powerplant component 22 to be inspected. This engagement may temporarily fixedly couple the inspection scope 28 and its members 34 and 36 to the second powerplant component 66 as described below in further detail.

Referring to FIG. 1, the measurement system 32 is configured in signal communication (e.g., hardwired and/or wirelessly coupled) with the inspection scope 28 and its scope members 40 and 42 as well as the display 30. The measurement system 32 of FIG. 1 may be in signal communication with the scope members 40 and 42 through one or more (e.g., electrically conductive and/or optical) signal paths extending within the scope body 34. The measurement system 32 may be implemented with a combination of hardware and software. The hardware may include a signal generator 68 (e.g., an oscillating power source), an electrical meter 70, a memory 72 and at least one processing device 74, which processing device 74 may include one or more single-core and/or multi-core processors. The hardware may also or alternatively include analog and/or digital circuitry other than that described above.

The signal generator 68 is in signal communication with the processing device 74 such that operation of the signal generator 68 is controlled by the processing device 74. The signal generator 68 is also in signal communication with the vibration actuator 40 and its actuator piezoelectric device 52. This signal generator 68 is configured to energize the vibration actuator 40 and its actuator piezoelectric device 52 with an actuator voltage. More particularly, the signal generator 68 is configured to apply the actuator voltage across the vibration actuator 40 and its actuator piezoelectric device 52 during the inspection of the powerplant component 22.

The electrical meter 70 is in signal communication with the processing device 74. The electrical meter 70 is also in signal communication with the vibration sensor 42 and its sensor piezoelectric device 54. This electrical meter 70 is configured to measure a sensor voltage across the vibration sensor 42 and its sensor piezoelectric device 54. The electrical meter 70, for example, may be or otherwise include a voltage meter or a multimeter.

The memory 72 is configured to store software (e.g., program instructions) for execution by the processing device 74, which software execution may control and/or facilitate performance of one or more operations such as those described below. The memory 72 may be a non-transitory computer readable medium. For example, the memory 72 may be configured as or include a volatile memory and/or a nonvolatile memory. Examples of a volatile memory may include a random access memory (RAM) such as a dynamic random access memory (DRAM), a static random access memory (SRAM), a synchronous dynamic random access memory (SDRAM), a video random access memory (VRAM), etc. Examples of a nonvolatile memory may include a read only memory (ROM), an electrically erasable programmable read-only memory (EEPROM), a computer hard drive, etc.

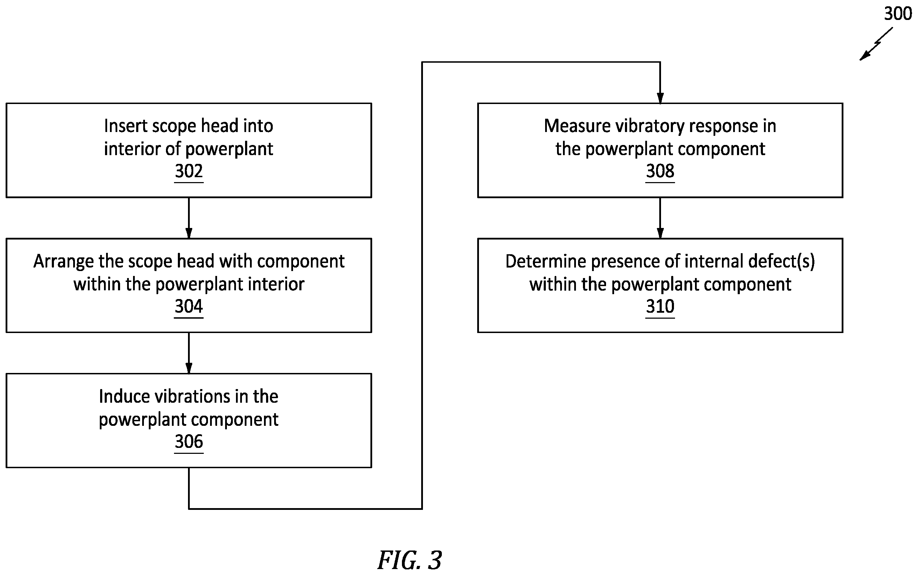

FIG. 3 is a flow diagram of a method 300 for inspecting the powerplant component 22 - a specimen component to be inspected. For ease of description, the inspection method 300 is described below with reference to the inspection system 20 of FIG. 1. The powerplant component 22 is also described below as being installed with the aircraft powerplant 24 and disposed within the interior 26 of the aircraft powerplant 24, where the aircraft powerplant 24 remains installed onboard the aircraft. The inspection method 300 of the present disclosure, however, may alternatively be performed with other inspection systems and/or while the aircraft powerplant 24 is removed from the aircraft and/or when the aircraft powerplant 24 is partially disassembled into one or more sub-assemblies.

In step 302, the scope head 36 is inserted into the interior 26 of the aircraft powerplant 24. An access cover, a powerplant component and/or the like, for example, may be removed from the aircraft powerplant 24 or opened to provide an access port into the interior 26 of the aircraft powerplant 24. The scope head 36 may then be passed through the access port into the interior 26 of the aircraft powerplant 24.

In step 304, the scope head 36 is arranged with the powerplant component 22 within the interior 26 of the aircraft powerplant 24. The inspection scope 28 and its scope head 36, for example, may be maneuvered to locate the scope head 36 and its stack 60 next to the powerplant component 22. This maneuvering may include passing the scope head 36 through one or more passages, ducts, conduits, plenums, ports, etc. within the aircraft powerplant 24 until, for example, the scope head 36 is arranged next to an inspection location on the powerplant component 22. The inspection scope 28 and its scope head 36 may then be further maneuvered to push the stack 60 and its vibration sensor 42 up against the powerplant component 22 and its component surface 64 at the inspection location. For example, referring to FIGS. 2A-C, the stack 60 and its vibration sensor 42 may be abutted against the powerplant component 22, where the vibration sensor 42 and its contactor head 62 rigidly engage (e.g., contact) the powerplant component 22 and its component surface 64 at the inspection location.

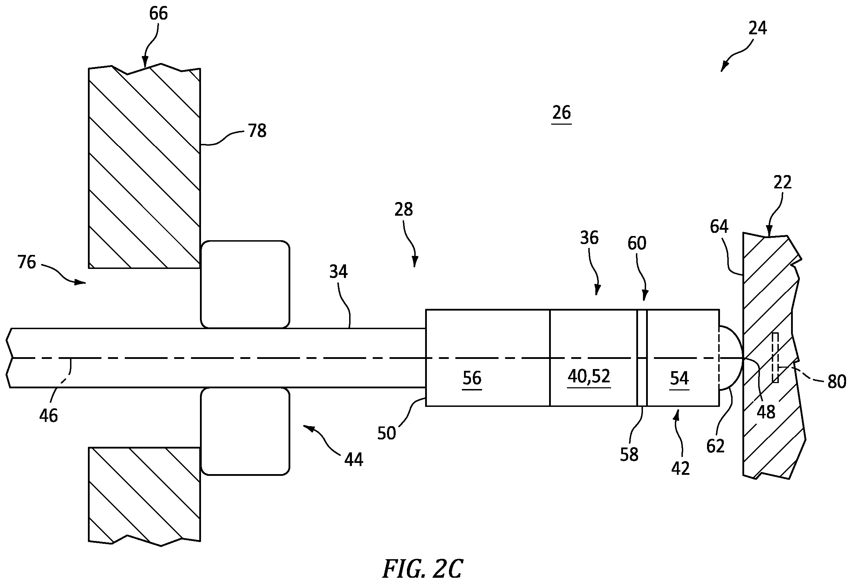

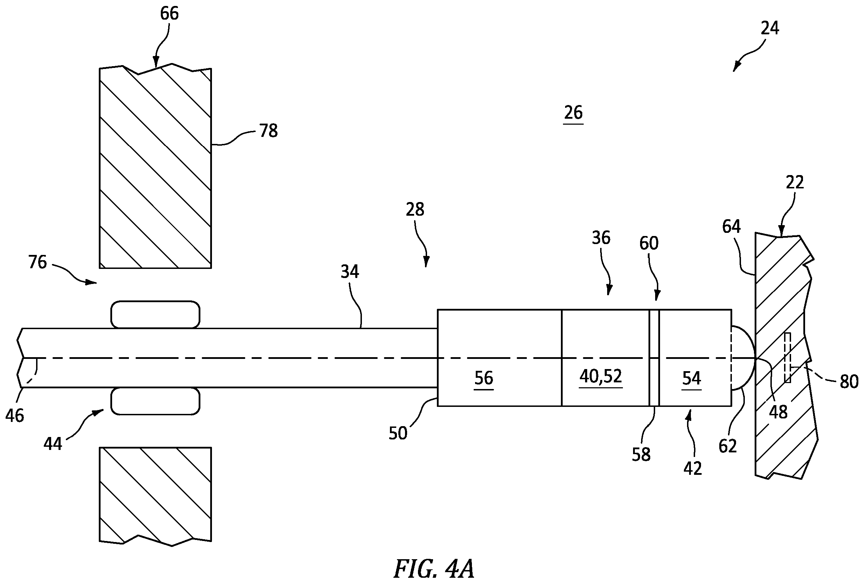

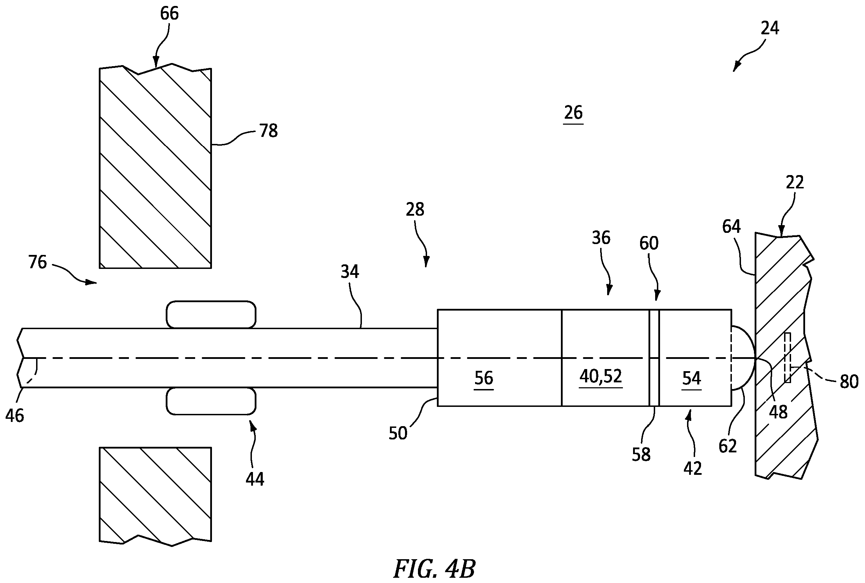

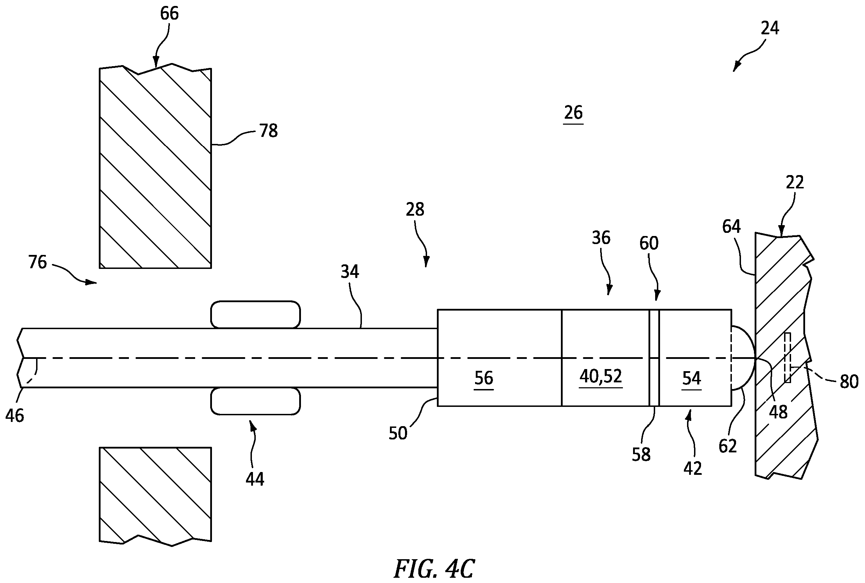

The position of the scope head 36 and its scope members 40 and 42 may then be fixed within the interior 26 of the aircraft powerplant 24 and relative to the powerplant component 22 using the scope anchor 44. For example, referring to FIG. 4A, the scope anchor 44 may be located within an aperture 76 in the second powerplant component 66 when the stack 60 and its vibration sensor 42 are abutted against the powerplant component 22 and its component surface 64. The scope anchor 44 may be expanded from the stowed arrangement (e.g., a retracted / contracted arrangement) of FIG. 4A to the deployed arrangement (e.g., an expanded arrangement) of FIG. 2A. In the deployed arrangement of FIG. 2A, the size of the scope anchor 44 is increased such that a radial outer periphery of the scope anchor 44 radially engages (e.g., contacts) a portion of the second powerplant component 66 forming the aperture 76. This engagement may center the inspection scope 28 and its inspection scope members 34 and 36 relative to the aperture 76. The engagement may also fix the position of the inspection scope 28 and its inspection scope members 34 and 36 relative to the aperture 76 through an interference fit. In another example, referring to FIG. 4B, the scope anchor 44 may be located partially within the aperture 76 and partially in a space between the powerplant components 22 and 66 when the stack 60 and its vibration sensor 42 are abutted against the powerplant component 22 and its component surface 64. With this arrangement, following the deployment (e.g., expansion) of the scope anchor 44, an interference fit is formed at the radial engagement between the scope anchor 44 and the second powerplant component 66. In addition, the scope anchor 44 may also axially abut against a side 78 of the second powerplant component 66 facing the powerplant component 22 and its component surface 64. The scope anchor 44 may thereby longitudinally lock a position of the inspection scope 28 and its members 34, 36, 40 and 42 along the centerline 46. In still another example, referring to FIG. 4C, the scope anchor 44 may be located within the space between the powerplant components 22 and 66 when the stack 60 and its vibration sensor 42 are abutted against the powerplant component 22 and its component surface 64. With this arrangement, following the deployment (e.g., expansion) of the scope anchor 44, the scope anchor 44 of FIG. 2C may longitudinally lock the position of the inspection scope 28 and its members 34, 36, 40 and 42 along the centerline 46.

In addition to the foregoing, the stack 60 and each of its members 40, 58, 42 may be preloaded against the powerplant component 22 and its component surface 64. Here, the sensor piezoelectric device 54 is preloaded against the component surface 64 through the contactor head 62. The actuator piezoelectric device 52 is preloaded against the component surface 64 sequentially through the stack members 58, 54, 62. The preload may be equal to or greater than one or two pounds (1-2 lbs); e.g., between one and one-half pounds (1.5 lbs) and four and one-half pounds (4.5 lbs). The present disclosure, however, is not limited to such an exemplary preloads and may change based on transducer specifications.

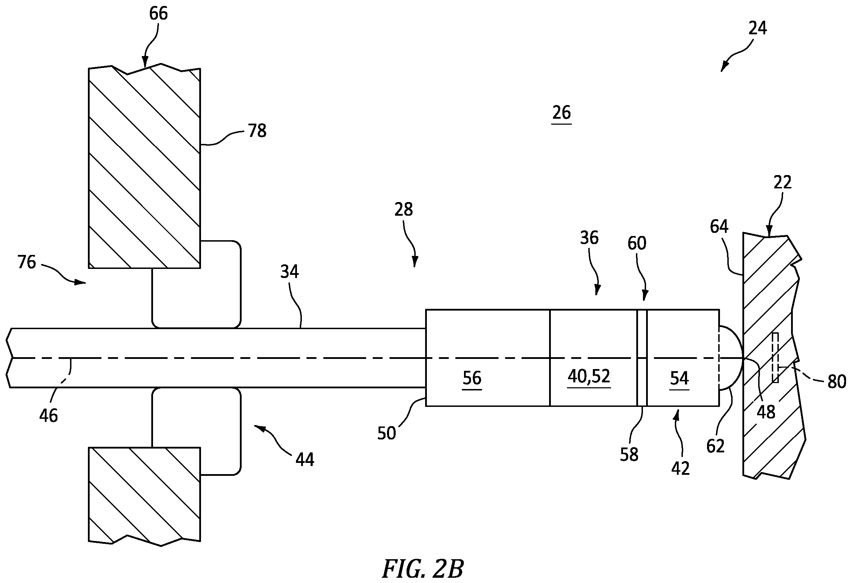

The preloading may occur during the abutting of the stack 60 and its vibration sensor 42 against the component surface 64. For example, in addition to placing the stack 60 and its vibration sensor 42 in contact with the component surface 64, the inspection scope 28 may be maneuvered to also exert some or all of the preload between the stack 60 and the component surface 64. In another example, in addition to fixing the position of the scope head 36 and its stack 60, the deployment of the scope anchor 44 may also push the stack 60 and its vibration sensor 42 longitudinally towards the powerplant component 22 (e.g., see FIGS. 2B and 2C) to also exert some or all of the preload between the stack 60 and the component surface 64. In still another example, following the deployment of the scope anchor 44, it is contemplated the scope body 34 or the scope head 36 may include another device (e.g., a longitudinal expansion joint) configured to further push the head base 56 and, thus, the stack 60 and its vibration sensor 42 towards the powerplant component 22 to exert some or all of the preload between the stack 60 and the component surface 64.

In step 306, vibrations are induced in the powerplant component 22 using the vibration actuator 40 at the inspection location. The processing device 74, for example, may signal the signal generator 68 to energize the vibration actuator 40 and its actuator piezoelectric device 52 with the actuator voltage. The energizing of the vibration actuator 40 and its actuator piezoelectric device 52 may generate vibrations, and the vibrations of the vibration actuator 40 and its actuator piezoelectric device 52 may be transmitted into the powerplant component 22 through the stack members 58, 54, 62 preloaded against the component surface 64. The vibrations may be induced to sweep across a range of frequencies during the step 306; e.g., a five kilohertz (5 kHz) range, a ten kilohertz (10 kHz) range, a twenty kilohertz (20 kHz) range, or any other suitable range which will facilitate mapping of a response signature as described below.

In step 308, a vibratory response is measured in the powerplant component 22 using the vibration sensor 42 at the inspection location. This vibratory response is induced by the vibrations transmitted into the powerplant component 22 by the vibration actuator 40. More particularly, the vibratory response energizes the vibration sensor 42 and its sensor piezoelectric device 54. The electrical meter 70 measures the sensor voltage across the sensor piezoelectric device 54, and provides a signal indicative of this measured sensor voltage to the processing device 74. The processing device 74 subsequently processes the sensor voltage with the actuator voltage to provide response data indicative of the measured vibratory response in the powerplant component 22. The sensor voltage, for example, may be processed with the actuator voltage using a mathematical transfer function to determine the response data. It has been found using this approach to determine the response data provides an improved signal to noise ratio than other approaches which measure, for example, electrical current and/or electrical impedance to a piezoelectric transducer.

In step 310, the response data is processed to determine whether or not the powerplant component 22 includes any internal defects 80 at and/or around the respective inspection location. Herein, the term "defect" may describe a physical anomaly present within a component which may negatively affect a useful life of that component and/or performance of that component. Examples of the internal defect(s) 80 include, but are not limited to, cracks, voids, corrosion, density variations, areas of poor solidification (e.g., sintering) and/or the like.

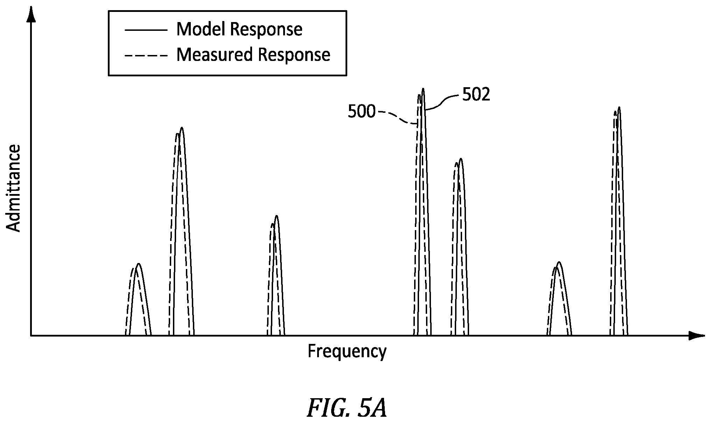

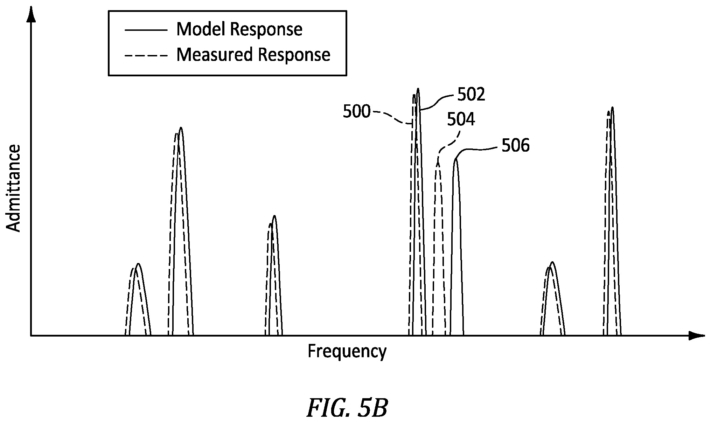

During the step 310, the measurement system 32 and its processing device 74 may analyze the measured vibratory response (e.g., the response data) to determine resonant frequencies and/or other structural mode parameters for the powerplant component 22. Referring to FIG. 5A, where these resonant frequencies (or other structural mode parameters) match (or are within tolerance of) corresponding expected resonant frequencies (or other structural mode parameters) for a model component (e.g., a computer modeled component, a previously inspected component, etc.) without any internal defects, the processing device 74 may determine the powerplant component 22 does not include, or there is a low probability that the powerplant component 22 includes, any internal defects. For example, a measured resonance signature 500 of the measured resonant frequencies in FIG. 5A is the same as, or is within tolerance of, a model resonance signature 502 of expected resonant frequencies for the model component without any internal defects. Note, the matching model and measured responses are shown in FIGS. 5A and 5B slightly laterally offset for clarity of illustration. By contrast referring to FIG. 5B, where one or more of the resonant frequencies and/or other structural mode parameters do not match (or are outside tolerance of) the corresponding expected resonant frequencies and/or other structural mode parameters for the model component without any internal defects, the processing device 74 may determine the powerplant component 22 does include, or there is a high probability that the powerplant component 22 includes, one or more internal defects 80. For example, the resonance signature 500 of the measured resonant frequencies in FIG. 5B includes an outlier resonant frequency 504 which is different than (e.g., does not align with) and is outside of tolerance of a corresponding resonant frequency 506 for the resonance signature 502 of the expected resonant frequencies for the model component without any internal defects. In the foregoing example, the powerplant component 22 and the model component have a common (e.g., the same) configuration and, thus, may share a common manufacturer component identification such as the same part number, the same assembly number, etc. Using this methodology, the inspection method 300 and the inspection system 20 may non-destructively identify presence of internal defect(s) 80 within the powerplant component 22 while that powerplant component 22 remains installed with the aircraft powerplant 24 and/or the aircraft powerplant 24 remains installed onboard the aircraft.

When the step 310 identifies presence of no internal defects in material of the powerplant component 22, information indicative of such may be presented on the display 30. This information may simply identify the presence of no internal defects. The information may also or alternatively indicate the inspected powerplant component 22 meets / is within a component specification (e.g., a design specification) for that powerplant component 22. The aircraft powerplant 24 may then be identified as being ready for continued operation assuming, for example, no other regular scheduled maintenance tasks and/or inspections need to be performed. Similarly, when the step 310 identifies the presence of internal defect(s) 80, information indicative of such may be presented on the display 30. This information may simply identify the presence of internal defects 80. The information may also or alternatively indicate the inspected powerplant component 22 does not meet / is outside of the component specification for that powerplant component 22. Inspection personnel may then take appropriate next steps to further inspect the powerplant component 22 and/or initiate a process for swapping out the aircraft powerplant 24, repairing the powerplant component 22 or replacing the powerplant component 22. While the inspection method 300 is described above identifying whether or not the inspected powerplant component 22 includes any internal defects 80, this inspection method 300 may also (or alternatively) be extended to determine one or more other physical characteristics about the inspected powerplant component 22.

After performing the step 308 or 310, the inspection scope 28 may be removed from the interior 26 of the aircraft powerplant 24. Alternatively, the inspection scope member(s) 36, 42, 60 may be (e.g., slightly) retracted from the powerplant component 22 and its component surface 64. Thus, when the powerplant component 22 is rotatable (e.g., where the powerplant component 22 is the rotor disk), the powerplant component 22 may be rotated about its rotational axis to facilitate repeating the foregoing inspection method 300 at another inspection location. Whether removing the inspection scope 28, retracting the inspection scope member(s) 36, 42, 60 and/or otherwise adjusting the inspection scope 28, the scope anchor 44 may be stowed (e.g., retracted) from the deployed arrangement of FIGS. 2A-C to the stowed arrangement of FIGS. 4A-C. The inspection scope 28 may then be free to maneuver within the interior 26 of the aircraft powerplant 24 as needed.

In some embodiments, the vibrations induced in the powerplant component 22 during the step 306 may have a frequency equal to or greater than thirty kilohertz (30 kHz); e.g., equal to or greater than forty kilohertz (40 kHz) or fifty kilohertz (50 kHz) up to about two hundred kilohertz (200kHz) or two hundred and fifty kilohertz (250kHz). This frequency may be a lower bound, an upper bound or an intermediate frequency within the range of frequencies swept during the vibration inducement step 306. By vibrating the powerplant component 22 at such a relatively high frequency, the inspection method 300 and/or the inspection system 20 may detect one or more internal defects 80 with a dimension (e.g., a width, a length, etc.) equal to or less than one hundred mils (0.10 inches) or one hundred and fifty miles (0.15 inches). More particularly, the inspection method 300 and/or the inspection system 20 may detect one or more internal defects 80 with a relatively small dimension equal to or less than fifty mils (0.05 inches); e.g., equal to or less than forty mils (0.04 inches). Here, the powerplant component 22 is constructed from a metal. It is contemplated, however, the vibrations may alternatively be induced at a frequency below thirty kilohertz (30 kHz) when detecting larger internal defect(s) 80 within the powerplant component 22 and/or when inspecting a powerplant component with another material construction.

While the inspection system 20 is described above with an in situ inspection device - the inspection scope 28, the present disclosure is not limited to such in situ inspection. The inspection device with its stack 60, for example, may alternatively be configured for inspecting the powerplant component 22 within a test environment; e.g., within a lab setting where the powerplant component 22 is completely disassembled from the aircraft powerplant 24.

While various embodiments of the present disclosure have been described, it will be apparent to those of ordinary skill in the art that many more embodiments and implementations are possible within the scope of the disclosure. For example, the present disclosure as described herein includes several aspects and embodiments that include particular features. Although these features may be described individually, it is within the scope of the present disclosure that some or all of these features may be combined with any one of the aspects and remain within the scope of the disclosure. Accordingly, the present disclosure is not to be restricted except in light of the attached claims and their equivalents.

## Claims

1. An inspection method, comprising:
arranging an inspection device with a specimen component (22), the inspection device including a piezoelectric actuator (40), an isolator (58) and a piezoelectric sensor (42), the piezoelectric actuator (40) engaging and preloaded against a surface of the specimen component (22) sequentially through the isolator (58) and the piezoelectric sensor (42), and the isolator (58) electrically isolating the piezoelectric actuator (40) from the piezoelectric sensor (42);
inducing vibrations in the specimen component (22) using the piezoelectric actuator (40);
measuring a vibratory response in the specimen component (22) excited by the vibrations using the piezoelectric sensor (42); and
providing response data indicative of the vibratory response measured using the piezoelectric sensor (42).

2. The inspection method of claim 1, wherein the measuring of the vibratory response comprises measuring a sensor voltage across the piezoelectric sensor (42).

3. The inspection method of claim 2, wherein the response data is provided based on the sensor voltage and an actuator voltage applied across the piezoelectric actuator (40) during the inducing of the vibrations.

4. The inspection method of claim 3, further comprising:
determining a measured resonance signature (500) of the specimen component (22) using the response data; and
comparing the measured resonance signature (500) to a model resonance signature (502) for a model component, wherein the specimen component (22) and the model component comprises a common configuration.

5. The inspection method of claim 4, wherein the model component is a computer modeled component.

6. The inspection method of claim 4, wherein the model component is a previously inspected component.

7. The inspection method of any preceding claim, further comprising determining a characteristic of the specimen component (22) using the response data.

8. The inspection method of any preceding claim, further comprising detecting a defect (80) internal to the specimen component (22) using the response data.

9. The inspection method of any preceding claim, wherein the isolator (58) is bonded to the piezoelectric actuator (40).

10. The inspection method of any preceding claim, wherein the isolator (58) is bonded to the piezoelectric sensor (42).

11. The inspection method of any preceding claim, wherein the isolator (58) comprises a ceramic.

12. The inspection method of any preceding claim, wherein:
the inspection device comprises an inspection scope (28); and
the piezoelectric actuator (40), the isolator (58) and the piezoelectric sensor (42) are included in a head (36) of the inspection scope (28).

13. The inspection method of any preceding claim, further comprising inserting the inspection device into an interior (26) of a powerplant (24), the powerplant (24) comprising the specimen component (22) within the interior (26) of the powerplant (24),
wherein, optionally:
the powerplant (24) comprises a turbine engine; and/or
the specimen component (22) is configured as a rotor disk; and/or
the powerplant (24) is installed with an aircraft during the inserting, the arranging, the inducing and the measuring.

14. An inspection method, comprising:
arranging an inspection device with a specimen component (22), the inspection device including an actuator (40) and a sensor (42), and the actuator (40) engaging and preloaded against a surface of the specimen component (22) through the sensor (42);
applying an actuation voltage across the actuator (40) to induce vibrations in the specimen component (22) using the actuator (40);
measuring a sensor voltage across the sensor (42) during inducement of the vibrations in the specimen component (22);
determining a measured resonance signature (500) of the specimen component (22) using the actuation voltage and the sensor voltage; and
comparing the measured resonance signature (500) to a model resonance signature (502) for a model component to determine a characteristic of the specimen component (22),
wherein, optionally, the inspection device further includes an isolator (58) arranged between the actuator (40) and the sensor (42), and the isolator (58) electrically isolates a piezoelectric device of the actuator (40) from a piezoelectric device of the sensor (42).

15. A system (20) for inspecting a specimen component (22), comprising:
an inspection device including an actuator (40), an isolator (58) and a sensor (42) arranged in a stack (60), the isolator (58) configured to electrically isolate the actuator (40) from the sensor (42), the inspection device configured to preload the actuator (40) against a surface of the specimen component (22) sequentially through the isolator (58) and the sensor (42), the actuator (40) comprising a piezoelectric device configured to induce vibrations in the specimen component (22), and the sensor (42) comprising a piezoelectric device configured to measurer a vibratory response in the specimen component (22);
a voltage meter (70) configured to measure a sensor voltage across the piezoelectric device of the sensor (42) during inducement of the vibrations in the specimen component (22) by the actuator (40); and
a processing device (74) configured to determine a characteristic of the specimen component (22) using the sensor voltage and an actuation voltage applied across the piezoelectric device of the actuator (40) to induce the vibrations in the specimen component (22),
wherein, optionally, the sensor (42) is solely connected to the actuator (40) through the isolator (58), and the isolator (58) comprises a ceramic.
